# FASCICULE DE BREVET EUROPEEN

(11) **EP 2 599 138 B1**
(45) Date de publication et mention de la délivrance du brevet: **02.03.2016**
(21) Numéro de dépôt: 11749922.8
(22) Date de dépôt: 21.07.2011
(51) Int. Cl.: B82Y 25/00, H01L 43/08, G11C 11/16, H01F 10/32, H01F 10/12

(54) **ELEMENT MAGNETIQUE INSCRIPTIBLE**
BESCHREIBBARES MAGNETISCHES ELEMENT
WRITEABLE MAGNETIC ELEMENT

(30) Priorité: 26.07.2010 FR 1003122
(43) Date de publication de la demande: 05.06.2013
(73) Titulaire: Centre National de la Recherche Scientifique, 75016 Paris (FR); Commissariat à l'Énergie Atomique et aux Énergies Alternatives, 75015 Paris (FR); Université Joseph Fourier, 38041 Grenoble Cedex 9 (FR); Institut Català De Nanotecnologia (ICN), 08193 Bellaterra (ES); Institució Catalana de Recerca i Estudis Avançats, 08010 Barcelona (ES)
(72) Inventeur: GAUDIN, Gilles Louis, F-38700 Le Sappey (FR); MIRON, Ioan Mihai, E-08301 Mataro (ES); GAMBARDELLA, Pietro, E-08197 Sant Cugat Del Valles (ES); SCHUHL, Alain, F-38000 Grenoble (FR)
(74) Mandataire: Gevers & Orès
(86) Numéro de dépôt international: PCT/IB2011/053259
(87) Numéro de publication internationale: WO 2012/014132

(56) Documents cités:
- EP-A1- 1 942 527
- WO-A2-2005/109517
- FR-A1- 2 910 716
- US-A1- 2009 003 042
- MIRON I M ET AL: "Current-driven spin torque induced by the Rashba effect in a ferromagnetic metal layer", NATURE MATERIALS NATURE PUBLISHING GROUP UK, vol. 9, no. 3, mars 2010 (2010-03), pages 230-234, XP002634560, ISSN: 1476-1122 cité dans la demande

## Description

La présente invention a pour objet un élément magnétique inscriptible du type à retournement induit par un courant.

Le retournement de l'aimantation d'une couche ou d'un petit élément magnétique se fait communément au moyen d'un champ magnétique appliqué. La direction de celui-ci est changée suivant que l'on veuille retourner l'aimantation dans un sens ou dans un autre. C'est ce principe qui est à la base de l'écriture dans des pistes magnétiques ou des disques durs d'ordinateur : l'élément à retourner est mécaniquement placé au voisinage du générateur de champ magnétique de façon à localiser spatialement ce champ. C'est en effet la structure même du champ magnétique, par définition non localisé dans l'espace, qui soulève de nombreuses difficultés pour son intégration dans des dispositifs. Ainsi, lorsque qu'aucune actuation mécanique n'est possible ou désirée, par exemple dans le cas des mémoires magnétiques solides de type "MRAM" (magnetic random access memory) ou des dispositifs logiques, il faut localiser suffisamment le champ magnétique pour que celui-ci n'agisse que sur la cellule cible sans impacter ses voisines. Ce problème devient de plus en plus important lorsque les différentes cellules mémoire ou logiques sont disposées très proches les unes des autres afin d'augmenter les densités.

La possibilité de manipuler l'aimantation au moyen d'un courant polarisé en spin qui a été démontrée tout d'abord théoriquement en 1996 a apporté une première solution à ce problème. Ce principe physique, appelé couple de transfert de spin (STT pour spin transfer torque en anglais) nécessite la présence, pour manipuler l'aimantation au niveau du point mémoire, d'au moins deux couches magnétiques séparées par un métal non magnétique (pour une structure de type vanne de spin) ou par un isolant (pour une structure de type jonction tunnel magnétique), les deux couches ayant leur aimantations non colinéraires. L'explication physique détaillée diffère suivant que l'on est en présence d'une structure vanne de spin ou jonction tunnel magnétique mais globalement le courant se polarise en spin à la traversée de la première couche magnétique, pour ensuite exercer un couple sur l'aimantation de la seconde couche au moyen de la composante non colinéaire de la polarisation du courant. Lorsque les densités de courant sont suffisantes, l'aimantation de la seconde couche magnétique peut être retournée à la fois pour les vannes de spin et les jonctions tunnel magnétiques.

Comme décrit par exemple dans le Brevet US 7 009 877 publié le 7 Mars 2006 et dans la Demande US 2009/129143 publiée le 21 Mai 2009, le courant électrique d'écriture traverse nécessairement la jonction perpendiculairement au plan des couches.

Cette possibilité de manipuler localement l'aimantation d'un élément magnétique de taille sub-micronique au moyen d'un courant électrique a tout de suite généré des possibilités d'application. De nos jours, c'est l'intégration de ce principe dans les nouvelles architectures de cellules mémoire MRAM et des composants logiques qui est recherchée par les acteurs industriels.

Cette intégration se heurte pour l'instant à différentes difficultés qui semblent entrelacées.

Le retournement par STT nécessite la présence au niveau du point mémoire d'au moins deux couches magnétiques séparées par un espaceur non magnétique. L'écriture se fait comme décrit ci-dessus en injectant un courant de forte densité à travers tout l'empilement, perpendiculairement au plan des couches magnétiques. La lecture se fait au moyen de la magnétorésistance de l'empilement : magnétorésistance géante (GMR) pour les vannes de spin, et magnétorésistance tunnel (TMR) pour les jonctions tunnel magnétiques. De nos jours, toutes les applications ou presque sont basées sur l'utilisation de jonctions tunnel magnétiques. Ainsi, si le signal GMR n'est que de quelques pourcents, le signal TMR de jonctions à base de MgO est communément supérieur à 100%. Les jonctions tunnel ont néanmoins le désavantage de présenter des valeurs du produit résistance * surface (RA) importantes. Ainsi, pour une densité de courant typique de 10⁷ A/cm² nécessaire au retournement par STT, la tension aux bords de la jonction est de 10 V pour un RA de 100Ω.µm², 1V pour un RA de 10 Ω.µm² et 0,1 V pour un RA de 1 Ω.µm². Hormis pour la valeur la plus faible, la puissance dissipée dans la jonction est alors importante ce qui est préjudiciable à la fois en terme de consommation énergétique et d'endommagement de la dite jonction. De plus, les valeurs importantes de TMR utiles à la lecture sont souvent obtenues pour des empilements présentant des valeurs de RA importantes. Cela explique les recherches actuelles pour obtenir des jonctions tunnel présentant de fortes valeurs de TMR et de faibles valeurs de RA. De plus, même pour des valeurs relativement faibles de tension aux bords de la jonction, des phénomènes de vieillissement accéléré de la jonction dus aux cycles en tension ont été observés en fonctionnement. De nombreuses études sont consacrées actuellement à ce point à la fois pour optimiser les matériaux dans les géométries existantes mais aussi pour définir de nouvelles géométries permettant de découpler autant que possible les problématiques d'écriture et de lecture, par exemple en utilisant des géométries à trois terminaux.

En résumé, une difficulté réside dans l'impossibilité d'optimiser indépendamment la lecture et l'écriture car, dans les dispositifs à transfert de spin (STT) connus, les deux phénomènes sont intrinsèquement liés.

Une difficulté qui en résulte est liée au fait que l'écriture nécessite de faire passer un courant de très forte densité à travers l'empilement, comme indiqué ci-dessus.

Une autre difficulté inhérente encore à ce lien provient de la complexité toujours plus grande des empilements. Ainsi, si l'on veut que l'effet de transfert de spin (STT) ne se fasse ressentir que dans la couche à retourner pour stocker l'aimantation, il faut par exemple stabiliser les autres couches au moyen d'un couplage d'échange avec un matériau antiferromagnétique ; si l'on veut augmenter l'amplitude du transfert STT, il faut optimiser les couches polarisantes ; si l'on veut diminuer les champs magnétiques rayonnés sur les couches sensibles, il faut utiliser par exemple des bicouche antiferromagnétiques artificielles ; etc...

Il en résulte que les empilements magnétiques typiques de cellules MRAM ou composants logiques peuvent comporter plus de 10 ou 15 couches différentes de matériaux divers. Ceci pose ensuite des difficultés dans les étapes de structuration et notamment dans l'étape de gravure qui est un des points de blocage les plus importants pour l'intégration de ces empilements magnétiques.

Une autre voie de recherche est de manipuler l'aimantation au moyen d'un champ électrique local. Ceci peut être partiellement accompli en modifiant l'anisotropie d'un matériau au moyen d'un champ électrique extérieur, le retournement de l'aimantation s'effectuant au moyen d'un champ magnétique appliqué. Une telle technique est décrite dans l'article de T. MARUYAMA et collaborateurs intitulé « Large voltage-induced magnetic anisotropy charge in a few atomic layers of iron » (Nature Nanotechnology, vol. 4, March 2009 - Macmillan Publishers Ltd.).

Cette technique ne permet actuellement que de réduite l'anisotropie magnétique du matériau. Les processus d'écriture et de lecture sont alors les mêmes que ceux décrits précédemment, ainsi que les inconvénients.

Un système de mémoire connu est décrit par le brevet français FR 2 910 716 A1.

La présente invention a pour objet un élément magnétique inscriptible qui, pour inverser l'aimantation, ne nécessite la présence que d'une couche magnétique (ayant une aimantation perpendiculaire à son plan) et qui fonctionne sans que le courant d'écriture ne traverse l'empilement dans une direction perpendiculaire aux couches.

L'invention concerne ainsi un système d'écriture d'un élément magnétique inscriptible selon la revendication 1.

La mémoire est écrite dans un sens d'aimantation ou dans l'autre en agissant sur le sens du champ magnétique d'écriture qui est appliqué.

L'aimantation perpendiculaire au plan de la couche centrale résulte de l'anisotropie propre du matériau de la couche centrale, soit d'une anisotropie induite par exemple par les interfaces pour ce matériau.

Le courant électrique circule parallèlement à la couche magnétique et ne traverse pas l'empilement perpendiculairement aux couches, et la mémoire peut être écrite à "1" ou à "0" en agissant, en présence dudit courant et notamment en présence d'une impulsion de courant, sur le sens du champ magnétique appliqué.

L'invention met à profit comme il sera expliqué ci-après un champ magnétique efficace dû au champ Rashba et à l'interaction d'échange s-d, agissant sur l'aimantation locale, ce champ étant dénommé ci-après champ de spin-orbite. Ce champ de spin-orbite est orthogonal à la fois au courant et au champ électrique perpendiculaire au plan des interfaces dû à l'asymétrie de l'empilement, et donc dans la géométrie de l'invention à la direction de l'anisotropie de l'empilement, et permet de diminuer la barrière d'énergie séparant deux configurations stables d'aimantation. Le champ magnétique appliqué est orienté dans le sens vers lequel on veut orienter l'aimantation. Son amplitude est insuffisante pour retourner l'aimantation en l'absence de courant, mais suffisante pour le faire en sa présence.

La couche centrale a avantageusement une épaisseur comprise entre 0,1 nm et 5 nm et de préférence inférieure ou égale à 2 nm.

La couche centrale comporte avantageusement un composé magnétique présentant une anisotropie magnétique perpendiculaire propre, à savoir notamment un alliage FePt, FePd, CoPt, CoPd, ou bien encore un alliage de terre rare / métal de transition qui présente également une anisotropie magnétique propre perpendiculaire au plan des couches, tel que GdCo, ou TbFeCo.

La couche centrale comporte avantageusement un métal ou un alliage présentant une anisotropie magnétique perpendiculaire induite par les interfaces, notamment Co, Fe, CoFe, Ni, CoNi...

Au moins une couche externe conductrice est avantageusement en un métal non magnétique en particulier en Pd, Cd, Cu, Au, Bi, Ir, Ru, W ou en un alliage de ces métaux. L'épaisseur d'une telle couche conductrice est par exemple comprise entre 0,5 nm et 100 nm, plus particulièrement entre 0,5 nm et 10 nm et de préférence inférieure ou égale à 5 nm. L'épaisseur de cette couche peut être choisie indépendamment de celle de la couche centrale.

La première couche externe lorsqu'elle est non électriquement conductrice, est avantageusement en un oxyde diélectrique tel que SiOx, AlOx, MgOx, TiOx, TaOx ou bien en un nitrure diélectrique tel que SiNx, BNx. L'épaisseur de cette couche externe peut être par exemple comprise entre 0,5 nm et 200 nm, plus particulièrement entre 0,5 nm et 100 nm, et de préférence inférieure à 3nm notamment si la lecture de l'élément mémoire se fait au moyen du signal de magnétorésistance tunnel.

Les deux couches externes peuvent être électriquement conductrices, mais elles sont alors choisies en deux dits métaux ou alliages de métaux non magnétiques différents.

La densité du courant est comprise par exemple entre 10⁴ A/cm² et 10⁹ A/cm², et avantageusement entre 10⁵ A/cm² et 10⁸ A/cm².

Le champ magnétique peut présenter une valeur comprise entre 20 Oe (0,002 T) et 10000 Oe (1 T) et avantageusement entre 50 Oe (0,005 T) et 800 Oe (0,8 T).

La première couche externe peut être recouverte d'une couche de lecture en matériau magnétique et d'une électrode de lecture.

Dans le cas où la première couche externe est en métal non magnétique, elle forme avec la couche centrale magnétique, la couche de lecture et l'électrode de lecture une vanne de spin. L'épaisseur de la première couche externe est alors inférieure à 10 nm et de préférence inférieure à 5 nm.

Dans le cas où la première couche externe est diélectrique, elle forme avec la couche centrale magnétique, la couche de lecture et l'électrode de lecture une jonction tunnel magnétique. L'épaisseur de la première couche externe est inférieure à 5 nm, par exemple comprise entre 0,5 nm et 5 nm et de préférence inférieure à 3 nm.

La première couche externe et la couche centrale peuvent former un plot, alors que la deuxième couche externe forme éventuellement une piste.

Selon une variante, la couche externe comporte une région en surépaisseur qui fait partie du plot.

L'invention concerne également un dispositif magnétique inscriptible comportant une pluralité de dits plots, alors que la deuxième couche externe de l'empilement est constituée par une dite piste qui leur est commune.

Alternativement, le dispositif magnétique inscriptible est caractérisé en ce que la première couche externe, la couche centrale et la deuxième couche externe forment un plot, et en ce qu'il comporte une pluralité desdits plots, ainsi d'une piste électriquement conductrice bordant la deuxième couche externe desdits plots pour injecter ledit courant à travers la deuxième couche externe et la couche centrale de chacun desdits plots, la deuxième couche externe étant en un matériau électriquement conducteur différent de celui de la piste électriquement conductrice.

L'invention sera mieux comprise à la lecture de la description ci-après, en liaison avec les dessins dans lesquels les figures 1a à 1f illustrent une mise en oeuvre de l'invention, dont les figures 2a et 2b représentent un mode de réalisation intégré dans une cellule mémoire magnétique de type "MRAM", et dont les figures 3a à 3d illustrent des modes de réalisation dans chacun desquels plusieurs éléments de mémoire sont représentés pour illustrer l'architecture de la mémoire.

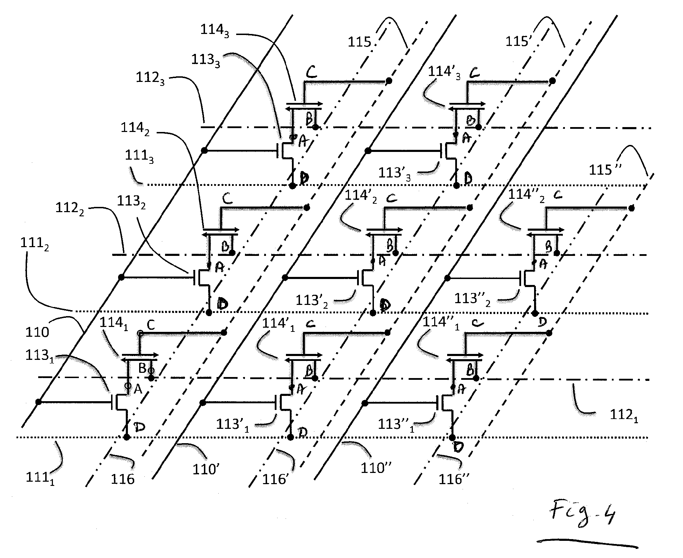

La figure 4 est un exemple d'intégration d'un élément magnétique selon l'invention constituant une cellule mémoire, pour former un réseau mono ou bi-dimensionnel.

L'empilement mis en oeuvre dans le cadre de la présente invention, à savoir une couche magnétique centrale, en sandwich entre deux couches externes non magnétiques, dont au moins une est conductrice, les deux couches externes étant en des matériaux différents, a pour effet de créer une asymétrie d'inversion qui génère un champ électrique non compensé dans la couche centrale magnétique. Les électrons se propageant dans ce champ électrique sont soumis dans leur référentiel propre à un champ magnétique appelé champ Rashba *̅H̅_̅{̅R̅}̅*̅.̅ Le champ Rashba *H̅_{R̅}* est perpendiculaire à la fois au courant circulant dans la couche conductrice et au champ électrique. Il s'applique donc sur les électrons de conduction.

Les inventeurs ont montré qu'un champ magnétique effectif (dénommé champ magnétique de spin-orbite) qui résulte de ce champ Rashba et de l'interaction d'échange s-d couplant le spin des électrons itinérants et localisés s'applique sur l'aimantation locale.

Ainsi, l'article de Ioan Mihai MIRON et Collaborateurs, intitulé « Current-driven spin torque induced by the Rashba effect in a ferromagnetic metal layer » publié dans Nature Materials, vol. 9, p. 230-234 (2010), montre un empilement comportant une couche de Pt (3 nm) une couche de Co (0,6 nm) ayant une aimantation perpendiculaire à son plan et donc parallèle à l'axe z, et une couche de AlOx (2 nm) parcourue par un courant circulant parallèlement à l'axe x. Cet empilement présente un champ magnétique effectif H_{eff} (ou champ de spin-orbite) selon le troisième axe du trièdre, l'axe y. Cette configuration est de ce fait inappropriée à la réalisation d'une mémoire, car ce champ magnétique n'est pas colinéaire à l'aimantation de la couche.

Les inventeurs ont montré néanmoins que ce champ magnétique de spin-orbite permet de diminuer de manière inattendue le champ magnétique appliqué nécessaire au retournement de l'aimantation de la couche magnétique. Selon leur interprétation, la barrière d'énergie séparant les deux configurations stables d'aimantation perpendiculaire est diminuée en mettant à profit ce champ magnétique de spin-orbite lorsqu'un courant est injecté dans une structure présentant une asymétrie d'inversion. Le champ magnétique appliqué nécessaire au retournement de l'aimantation entre ces deux configurations stables est alors diminué par rapport à sa valeur en l'absence de courant injecté. Le sens de ce champ magnétique appliqué est donc celui dans lequel on veut orienter l'aimantation.

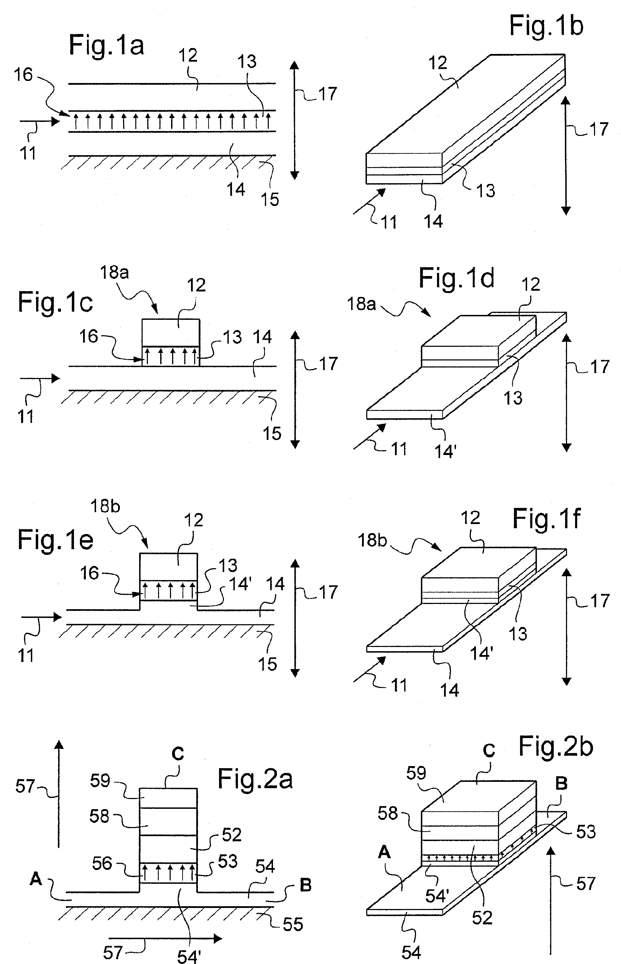

Les figures 1a à If illustrent la mise en oeuvre de l'invention, selon laquelle la direction du champ magnétique appliqué est perpendiculaire à la direction du courant et à la direction du champ de spin-orbite et parallèle à la direction de l'aimantation qui est perpendiculaire au plan de la couche centrale magnétique.

La référence 15 désigne un substrat qui est un isolant électrique, afin de ne pas court-circuiter la structure. Il peut être notamment constitué par un oxyde diélectrique (par exemple SiOx, AlOx, MgOx), ou par un nitrure par exemple SiNx. Il peut être seul ou déposé sur un autre substrat par exemple en silicium.

La référence 13 désigne la couche magnétique plane dont l'aimantation est perpendiculaire à son plan. La référence 16 désigne l'orientation de l'aimantation qui peut être présente dans un sens ou dans le sens opposé.

Les références 12 et 14 désignent respectivement les première et deuxième couches externes non magnétiques. La deuxième couche externe 14 est celle qui est parcourue par le courant d'écriture.

La référence 11 désigne la direction du courant qui est parallèle au plan de la couche 13, et la référence 17 désigne l'orientation du champ magnétique appliqué, qui est parallèle à la direction de l'aimantation, et donc perpendiculaire au plan de la couche centrale 13 et qui peut être présente dans un sens ou dans le sens opposé.

Les figures 1a et 1b montrent un empilement non structuré dans lequel les couches 12, 13 et 14 de l'empilement forment une piste.

Les figures 1c à 1f montrent un empilement structuré dans lequel la couche 14 est conductrice et les couches magnétique 13 et non magnétique 12 sont seules structurées pour former des plots 18a (figures 1c et 1d) ou bien dans lequel les trois couches 12, 13, 14 sont structurées pour constituer un plot 18b intégrant une surépaisseur 14' de la couche conductrice 14, de sorte que le plot contienne une partie de l'épaisseur du matériau non magnétique de la couche 14 (figures 1e et 1f). L'épaisseur à prendre en compte pour la deuxième couche externe est celle de la couche 14 proprement dite, plus celle de la surépaisseur 14'.

On notera que la région en surépaisseur 14' n'est pas nécessairement dans le même matériau électriquement conducteur que la couche 14, auquel cas c'est seulement cette surépaisseur 14' qui fait fonction de deuxième couche externe non magnétique et c'est son matériau qui est fonctionnel dans l'empilement pour obtenir une asymétrie d'inversion. Le matériau métallique de la couche 14 peut alors être quelconque.

La formation de plots 18a ou 18b permet de ne retourner l'aimantation que dans les plots, sinon l'aimantation est retournée sur toute la longueur de la piste.

La couche magnétique 13 présente une aimantation perpendiculaire et a une épaisseur assez fine pour que le champ électrique dû aux interfaces ne soit pas négligeable. Son épaisseur ne dépasse typiquement pas 2 nm et elle est au maximum de 5 nm. Tous les matériaux magnétiques présentant une aimantation perpendiculaire, due par exemple à leur anisotropie magnétique perpendiculaire propre (alliages FePt, FePd, CoPt.... ; alliages terre rare/métaux de transition GdCo, TbFeCo...) ou à une anisotropie magnétique perpendiculaire induite par les interfaces (Co, Fe, CoFe, Ni, CoNi, ....) peuvent être utilisés. On peut aussi prendre des matériaux magnétiques non métalliques comme par exemple des semi-conducteurs magnétiques, tels que GaMnAs (GaAs dopé au Mn) On notera que les matériaux semi-conducteurs magnétiques connus ne sont magnétiques qu'à une température inférieure à l'ambiante.

Dans le cas où l'anisotropie perpendiculaire du matériau magnétique est induite par les interfaces, on peut obtenir une aimantation perpendiculaire au plan en agissant sur l'épaisseur de la couche centrale et/ou sur l'état d'oxydation d'une couche externe en oxyde par exemple en modifiant les paramètres du dépôt de cette couche externe en oxyde ou en effectuant un recuit après la réalisation de l'empilement.

Exemple : Un empilement comportant une couche 14 conductrice en Pt (d'épaisseur 2 nm), une couche centrale 13 en Co (d'épaisseur 1 nm) et une couche 12 en AlOx présente pour un état d'oxydation donné de cette couche d'AlOx, une aimantation perpendiculaire, alors que si l'épaisseur de la couche en Co est égale à 1,5 nm, l'aimantation est dans le plan. Si l'empilement subit un recuit à 300°C pendant 60 minutes sous vide, alors l'aimantation de la couche centrale 13 en Co est perpendiculaire au plan. Au-delà d'une épaisseur de 3nm pour la couche en Co, on ne pourra pas obtenir d'aimantation hors du plan quel que soit le recuit ou les paramètres d'oxydation si la couche 12 est en AlOx. Si par contre le diélectrique utilisé pour la couche 12 est MgOx, on pourra obtenir une aimantation perpendiculaire pour une épaisseur de la couche centrale supérieure à 3nm.

L'influence de l'épaisseur d'une couche de cobalt sur les propriétés magnétiques pour différents oxydes (AlOx, MgOx, SiOx) est décrite dans l'article "Domain Patterns and Magnetization reversal Behaviours in Oxide/Co/Pt Films" de Jae Chul LEE et Collaborateurs, paru dans IEEE Transactions on Magnetics, vol. 46 n° 6 June 2010.

L'effet de l'oxydation et du recuit sur les propriétés magnétiques dans les tri-couches Pt/Co/AlOx a été décrit dans l'article 'Influence of Thermal annealing on the perpendicular magnetic anisotropy of Pt/Co/AlOx trilayers" de B. RODMACQ et collaborateurs, paru dans Physical Review B79 024423 (2009).

L'influence de l'état d'oxydation d'une couche d'oxyde sur les propriétés magnétiques de la couche de cobalt dans un empilement tri-couche platine/cobalt/métal oxydé, a été décrite dans l'article "Analysis of oxygen induced anisotropy crossover in Pt/Co/MOx trilayers" de A. MANCHON et collaborateurs, paru dans Journal of Appplied Physics 104, 043914, (2008).

Les deux couches non-magnétiques 12 et 14 doivent être différentes afin de créer une asymétrie d'inversion dans la structure globale. On choisit avantageusement deux matériaux différents pour chacune de ces couches, par exemple un diélectrique pour l'une des deux et un métal pour l'autre, mais on peut choisir aussi un métal pour chacune d'entre elles. Le cas où les deux couches 12 et 14 sont diélectriques, n'est possible que si non ne structure pas un plot, mais une piste. On peut alors faire circuler le courant directement dans la couche centrale 13 qui constitue une piste.

Ainsi, chacune des deux couches non magnétiques 12 et 14 peut être constituée des matériaux suivants, avec la condition que ces couches soient différentes et que l'empilement global (couches 12, 13, et 14) soit à aimantation perpendiculaire : un oxyde diélectrique (SiOₓ, AlOₓ, MgOₓ, TiOₓ, TaOₓ, HfOₓ...), un nitrure diélectrique, (SiNₓ, BNₓ,...), un métal non magnétique (Pt, Pd, Cu, Au, Bi, Ta, Ru ...) un alliage non magnétique de ces métaux, un composé semi-conducteur organique ou non (par exemple GaAs, Si, Ge, ou Graphène liée si besoin à un "buffer" de croissance par exemple un métal tel que l'iridium.

Dans le cas ou les couches non magnétiques sont l'une ou l'autre conductrices, les deux couches externes ne doivent pas avoir la même composition.

L'épaisseur des couches 12 et 14 peut être choisie dans une large gamme de valeurs, typiquement de 0,5 à 200 nm d'épaisseur et plus particulièrement entre 0,5 nm et 100 nm. Dans le cas où la couche 12 est isolante, il n'y a pas d'inconvénient à ce que sa valeur atteigne une valeur importante, typiquement 100 nm sauf dans le cas où la lecture du point mémoire se fait au moyen du signal de magnétorésistance tunnel en rajoutant par exemple une couche magnétique et une électrode au dessus de cette couche isolante comme représenté sur les figures 2a et 2b. Dans ce cas l'épaisseur de cette couche isolante sera choisie préférentiellement inférieure à 3nm. Dans le cas de couches 12 et/ou 14 métalliques, on privilégie des couches fines, typiquement inférieures à 5 nm et généralement inférieures à 10 nm, de façon d'une part à ne pas trop diminuer le courant efficace passant dans la couche magnétique à cause de ces canaux conducteurs en parallèle et d'autre part de permettre la lecture du point mémoire au moyen du signal de magnétorésistance géante.

Ces différentes couches peuvent être déposées par toute technique connue telle que : évaporation, pulvérisation, dépôt par voie électrochimique, croissance chimique,....

La couche 14 peut être omise dans certaines géométries. La couche magnétique 13 est alors déposée directement sur le substrat isolant 15 (qui fait fonction de couche non magnétique) et la couche non magnétique 12 est choisie de façon à avoir l'asymétrie d'inversion, en un matériau différent de celui constituant le substrat 15. Il faut néanmoins remarquer que dans le cas où des plots sont structurés, la couche 14 doit être présente et constituée d'un matériau conducteur électrique de façon à pouvoir injecter du courant dans les plots structurés (ici 18a et 18b). Dans ce cas, la portion 14' en surplomb doit être également conductrice pour générer, en combinaison avec la couche 12, l'asymétrie d'inversion qui est recherchée pour générer un champ Rashba, et pour permettre d'injecter du courant dans la couche centrale magnétique 13.

L'élément à retourner, que ce soit la piste représentée (Figure la ou 1b) ou un plot reporté ou structuré sur la piste (Figures 1c à If), est connecté par des électrodes conductrices connues en soi, de façon à injecter un courant suivant la direction 11.

Le champ appliqué colinéairement à la direction d'aimantation et dans le sens dans lequel on veut orienter l'aimantation a une amplitude insuffisante pour retourner l'aimantation en l'absence d'impulsion de courant, mais suffisante en sa présence. Il peut donc se présenter sous forme d'une impulsion, soit parfaitement synchronisée avec une impulsion de courant, soit plus courte que l'impulsion de courant et contenu dans celle-ci, soit encore, et cette solution pourra être plus simple à intégrer dans des applications, avoir une durée plus longue que celle de l'impulsion de courant.

Ainsi, dans ce cas, le sens d'injection du courant peut être choisi arbitrairement, les deux sens ayant un effet similaire sur l'abaissement de la barrière d'anisotropie.

On peut également utiliser un courant constant, et générer un champ magnétique dans le sens désiré, mais cette solution est moins intéressante du point de vue de la consommation électrique, puisque l'aimantation est stable en l'absence de courant et qu'il n'y a besoin d'appliquer un courant dans la couche conductrice que lors d'une étape d'écriture et que si l'on utilise un courant constant, on diminue tout le temps la barrière d'énergie entre les deux états d'aimantation vers le haut et vers le bas, ce qui risque d'entraîner des basculements non désirés de l'aimantation.

Les valeurs du champ magnétique à appliquer sont liées à l'anisotropie du matériau, à son champ magnétique coercitif et à la densité de courant injecté. Typiquement ce champ peut être compris entre 20 Oe (0,002 T) et 10 kOe (1 T) et plus particulièrement entre 0,005 T et 0,8 T, tandis que les densités de courant peuvent être comprises entre 10⁴ et 10⁹ A/cm², et plus particulièrement entre 10⁵ et 10⁸ A/cm².

Plus la densité du courant appliqué lors d'une étape d'écriture est élevée, plus la valeur du champ à appliquer pour inverser l'aimantation est faible.

Le champ magnétique peut être appliqué de différentes façons, par exemple de façon simple à l'aide d'un courant parcourant une bobine de façon à générer un champ global sur l'ensemble du dispositif, et dans ce cas, ne seront retournés que les plots (points mémoire) dont la barrière d'énergie aura été réduite par un courant injecté, soit au moyen de pistes parcourues par un courant comme utilisées dans les mémoires MRAM connues à retournement induit par un champ magnétique.

Les figures 2a et 2b sont un exemple d'empilement utilisable dans une cellule de mémoire MRAM.

La référence 53 représente la couche centrale magnétique prise en sandwich entre deux matériaux non magnétiques différents 52 et 54 avec une surépaisseur 54' (optionnelle), pour réaliser l'empilement tel que décrit ci-dessus, sur un substrat 55 électriquement isolant.

La référence 57 désigne la direction du champ magnétique extérieur appliqué. Ce champ peut être appliqué selon l'un ou l'autre sens en fonction du sens recherché pour l'inscription désirée.

Au-dessus de l'empilement sont disposées pour la lecture une couche 58 d'un matériau magnétique et une électrode supérieure 59 pouvant contenir une ou plusieurs couches conductrices (magnétiques ou non magnétiques).

La fonction de la couche 58 est de permettre que la structure 53, 52, 58 présente des valeurs de résistance électrique différentes suivant le sens de l'aimantation 56 de la couche 53 (signal de magnétorésistance). Elle n'intervient que pour la lecture et n'a aucun effet sur la manipulation de l'aimantation de la couche 53.

En d'autres termes, l'écriture et la lecture sont définies de manière indépendante et peuvent être optimisées séparément.

L'électrode 59 peut comporter une couche ou bien de manière connue en soi un empilement de différentes couches fonctionnelles. Il peut contenir par exemple :
- un empilement définissant un antiferromagnétique synthétique de façon à limiter les champs rayonnés sur la couche que l'on cherche à manipuler 53, par exemple un empilement comprenant une couche ferromagnétique séparée de la couche ferromagnétique 58 par une très fine couche d'un matériau métallique non magnétique, typiquement 0,3 nm de ruthénium (Ru), les valeurs des aimantations des deux couches ferromagnétiques étant le plus proche possible de telle sorte que le couplage antiferromagnétique entre elles qui est dû à la présence de la couche de ruthénium résulte en un champ total rayonné par ces trois couches sur la couche 53 qui soit nul ou quasi nul ;
- ou bien un matériau magnétique antiferromagnétique couplé par échange à la couche 58 de façon à stabiliser cette couche 58 dite de référence ;
- ou bien des matériaux conducteurs non magnétiques pour réaliser des contacts électriques ;
ou encore une combinaison de ces différentes possibilités par exemple un matériau antiferromagnétique adjacent à un matériau ferromagnétique de manière à stabiliser l'aimantation de celui-ci par le couplage entre ces deux matériaux, ce matériau ferromagnétique étant séparé de la couche 50 par une fine couche métallique, typiquement 0,3 nm de Ru de façon que le couplage magnétique entre ces deux couches ferromagnétiques soit antiférromagnétique. Enfin, le première matériau magnétique est recouvert d'une ou plusieurs couches conductrices non magnétiques, par exemple 5 nm de Ta recouvert de 7 nm de Ru. On trouvera des exemples de telles combinaisons dans des empilements magnétiques utilisés pour le retournement par STT décrit par exemple dans B. DIENY et al., Int. J. Nanotechnology, vol. 7, 591 (2010).

Deux configurations principales peuvent être distinguées suivant la nature de la couche 52 : si elle est en métal non magnétique, la structure 53, 52, 58 est de type vanne de spin, tandis que si la couche 52 est diélectrique, la structure 53, 52, 58 est du type jonction tunnel magnétique. Dans le cas où la couche 52 est en métal non magnétique sont épaisseur est prise inférieure à 10 nm et de préférence inférieure à 5 nm tandis que dans le cas où la couche 52 est diélectrique, son épaisseur est prise inférieure à 5 nm et de préférence inférieure à 3 nm. Le signal de magnétorésistance étant beaucoup plus important pour les structures du type jonction tunnel magnétique, ce seront celles-ci qui seront privilégiées. De même, pour optimiser le signal de magnétorésistance, on privilégie dans l'un et l'autre cas, la configuration dans laquelle l'aimantation de la couche 58 est colinéaire, soit parallèle, soit antiparallèle, à celle de la couche 53.

A, B et C (Figures 2a et 2b) désignent trois bornes de connexion électrique. Dans la phase d'écriture, un courant est injecté entre les bornes A et B (de façon équivalente, une tension est appliquée entre ces bornes de façon à faire circuler un courant). Le courant passe dans la couche magnétique 53 et produit dans cette couche un champ magnétique efficace dû au champ Rashba et à l'interaction s-d, agissant sur l'aimantation locale (voir l'article précité de I. M. MIRON et collaborateurs). Ce champ magnétique efficace (ou champ de spin-orbite) en combinaison avec le champ extérieur appliqué permet selon l'invention, la manipulation de l'aimantation en mettant à profit la diminution de la barrière d'énergie séparant les deux configurations stables de l'aimantation. Un retournement de l'aimantation est obtenu si on applique un champ magnétique de sens opposé à celui de l'aimantation. Dans le cas où la couche 52 est constituée par un matériau diélectrique, le courant injecté latéralement ne passe pas à travers cette couche et ne l'endommage pas.

La lecture de l'information stockée, typiquement l'orientation de l'aimantation dans la couche 53, se fait aussi bien pour une structure de type jonction tunnel que de type vanne de spin, en injectant un courant de faible intensité (par exemple de l'ordre de quelques µA ou de quelques dizaines de µA pour le cas de jonctions tunnel) entre les bornes C et B (ou de façon équivalente entre les bornes C et A), et en mesurant la tension entre ces bornes ; ou bien en appliquant une tension constante entre les bornes C et B, (ou de façon équivalente entre les bornes C et A), et en mesurant le courant qui circule entre ces bornes de façon à mesurer dans tous les cas la résistance entre les bornes considérées.

Celle-ci présente deux valeurs différentes selon que la direction d'aimantation 56 est parallèle ou anti-parallèle à celle de la couche de référence 58. Le courant de lecture a une faible valeur de sorte que la barrière tunnel (dans le cas où la couche 52 est diélectrique) ne saurait être endommagée.

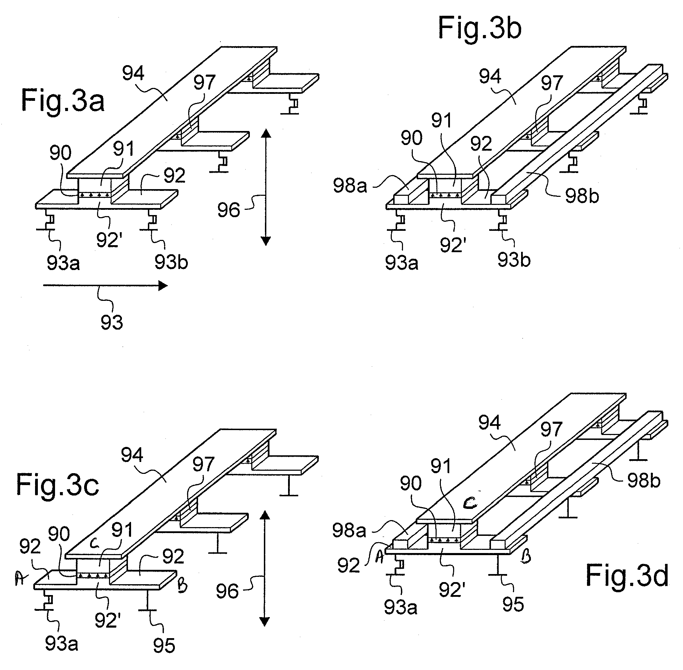

Des exemples d'architecture de mémoire seront maintenant présentés en relation avec les figures 3a à 3d, dans lesquelles les figures 3b et 3d mettent en oeuvre une génération du champ magnétique appliqué par des lignes de champ parcourues par un courant, avec mise en oeuvre de la structure des figures 2a et 2b.

Les figures 3a à 3d montrent des architectures possibles de mémoire utilisant le cas décrit. On retrouve la couche magnétique 90 à aimantation perpendiculaire 97 prise en sandwich entre deux couches non-magnétiques 91 et 92 (qui correspondent aux couches 12 et 14 des figures 1a à 1f et 52 et 54 des figures 2a et 2b).

Ici, pour simplifier, la couche 91 comprend à la fois cette couche 12 ou 52, mais aussi des couches magnétiques et non magnétiques permettant de définir un empilement de type jonction tunnel ou vanne de spin et ainsi de pouvoir lire l'état d'aimantation de la couche 90 (à la façon des couches 52, 58 et 59 des figures 2a et 2b).

Le retournement de l'aimantation de la couche 90 se fait au moyen d'un courant parcourant l'électrode inférieure 92 et d'un champ magnétique variable orienté selon la flèche 96 dans la direction de l'aimantation et dont le sens fait commuter l'aimantation dans la couche 90.

Pour ce faire, la seconde couche non magnétique constituant le sandwich 92 est ici structurée sous la forme d'une piste d'amenée de courant. Cette piste peut aussi être constituée par exemple d'une autre couche d'un autre matériau située sous la couche 92. L'injection du courant est contrôlée par des transistors.

Deux cas peuvent être pris pour exemple. Dans un premier cas, on utilise deux transistors 93a et 93b fonctionnant en commutation dont la borne libre est portée à la masse pour l'un et à une tension V_{dd} pour l'autre, la tension V_{dd} étant choisie pour faire circuler un courant de valeur choisie.

Dans un deuxième cas, on utilise un seul transistor 93a et l'autre extrémité de la piste 92 est portée à une tension fixe.

On remarquera ici que le sens du courant n'a pas d'influence sur le fonctionnement du mécanisme, et que quel que soit le sens du courant la barrière diminuera de la même façon.

Deux modes de fonctionnement sont alors possibles :
- Fonctionnement symétrique :
   La piste connectée par exemple au transistor 93a est portée à la tension V_{dd}, ou à la masse tandis que l'autre piste connectée au bout de la piste 92 en 95 est connectée à la masse (ou à V_{dd}). Cette configuration permet de générer plus de courant que celle qui suit.
- Fonctionnement asymétrique (préféré) :
   La piste connectée en bout de 92 par 95 est portée à un potentiel intermédiaire par exemple V_{dd/2}, tandis que celle reliée au transistor 93a est portée au potentiel V_{dd} ou à la masse suivant le sens voulu pour le courant. Cette configuration permet de générer moins de courant que celle décrite précédemment. L'invention permet d'injecter en mode d'écriture un courant d'écriture sur une surface bien plus petite que celles utilisées dans les techniques connues, et ce courant d'écriture est suffisant pour faire fonctionner le dispositif. Le fonctionnement asymétrique permet une économie de consommation sur le fonctionnement.

Dans le cas décrit ici, c'est le champ magnétique appliqué qui fait commuter l'aimantation. Ce champ magnétique 96 doit donc être variable et orienté parallèlement à la direction de l'aimantation. Une réalisation possible est représentée par les figure 3b et 3d. Le champ magnétique est généré par deux lignes de champ 98a et 98b placées de part et d'autre de l'empilement. Lorsqu'un courant passe à travers ces lignes, un champ magnétique perpendiculaire aux couches est généré au niveau de la couche magnétique 90. On peut dans certaines géométries omettre une de ces lignes de champ 98b par exemple, pour n'en garder plus qu'une. Ces lignes peuvent être par exemple réalisées sous forme de films conducteurs lors de l'étape de nanofabrication des structures.

La figure 4 est un exemple de schéma électrique d'intégration d'un élément de mémoire pour former un réseau de cellules mémoires à deux dimensions par exemple avec une jonction tunnel. Les dispositifs permettant d'appliquer un champ magnétique perpendiculaire au plan des couches sont figurés par les lignes 116, 116', 116", etc ..., par exemple une ligne de courant dans laquelle la direction du courant injecté donne la direction du champ magnétique que l'on peut orienter vers le haut ou vers le bas (c'est-à-dire dans un sens ou dans l'autre, perpendiculairement au plan des couches) selon que l'on veuille inscrire un "0" ou un "1".

La ligne de champ par exemple 116 permet de générer des impulsions de champ pendant les impulsions de courant d'écriture. Le champ est appliqué à tous les points mémoire de la ligne. Seul le point mémoire de cette ligne dans lequel est simultanément injecté le courant d'écriture peut être écrit.

Dans une direction, sont présentes des lignes de bit (bit line) ou lignes de digits 111₁, 111₂, 111₃, etc... connectées au drain des transistors 113₁, 113₂, 113₃, 113'₁, 113'₂, 113'₃, 113"₁, 113"₂, etc... et des lignes de bit conjuguées 112₁, 112₂, 112₃,... qui forment un réseau à deux dimensions.

Dans la direction perpendiculaire, on a des pistes de commande 110, 110', 110", ... des portes des transistors 113₁, 113₂, 113₃, 113'₁, 113'₂, 113'₃, 113"₁, 113"₂, etc... qui forment des lignes de mot (word lines).

Les repères 114₁, 114₂, 114₃, 114'₁, 114'₂, 114'₃, etc... désignent schématiquement un empilement selon l'invention comportant une jonction tunnel (ou une vanne de spin). La jonction tunnel ou la vanne de spin n'est pas traversée par un courant perpendiculairement au plan de ses couches lors d'une phase d'écriture, et elle n'est parcourue par un courant perpendiculairement au plan de ses couches que lors d'une phase de lecture.

Les points caractéristiques A, B et C ont été indiqués. Ils correspondent à ceux qui sont indiqués aux figures 2a et 2b, 3c, 3d (montage avec un seul transistor).

Les points A sont connectés aux sources des transistors 113₁, 113₂, 113₃, 113'₁, 113'₂, etc....

Les points B sont connectés à une ligne de bit conjuguée 112₁, 112₂, 112₃, etc... et les points C à une ligne de polarisation 115, 115', etc.... Les drains D des transistors 113₁, 113₂, 113₃, 113'₁, 113'₂, etc... sont connectés aux lignes de bit 111₁, 111₂, 111₃, etc...

Le bas des empilements 114₁, 114₂, etc... est donc la couche dont on change l'aimantation au moyen du courant d'écriture.

La source et le drain des transistors peuvent être inversés. Ainsi, les sources des transistors peuvent être connectées aux lignes de bits 111₁, 111₂, 111₃, etc... et les drains D aux points A.

Dans la phase d'écriture, d'un point mémoire, par exemple 114₁, la ligne de bit (ou "bit line") 111₁ et la ligne de bit conjuguée 112₁ qui sont associées à ce point mémoire sont portées au potentiel Vdd (ou à la masse) et à la masse (ou au potentiel Vdd) dans le cas du fonctionnement symétrique décrit ci-dessus pour permettre la génération du courant d'écriture. Les autres lignes de bit 111₂, etc..., et lignes de bit conjuguées 112₂, etc... associées aux autres points mémoire sont inactives. La ligne de mot 110 associée est portée au potentiel de commande nécessaire à la fermeture du transistor 113₁ (équivalent au transistor 73a ou 83a des figures précitées), pour permettre la circulation du courant d'écriture à travers le transistor 113₁. Simultanément, une impulsion traverse la ligne de champ 116 qui intéresse le point mémoire 114₁. Une ligne de champ 116, 116', 116", peut être constituée par exemple par une paire de lignes telles que 98a et 98b (figures 3b et 3d).

Le courant d'écriture passe donc entre les points A et B. De façon à n'écrire que cette cellule, les autres lignes de mot 110', 110", etc... sont portées au potentiel qui ouvre les transistors. Aucun courant d'écriture ne traverse l'empilement de type jonction tunnel ou vanne de spin perpendiculairement au plan de ses couches au risque de l'endommager. A cet effet, les lignes de polarisation 115, 115', etc... connectées aux points C des empilements sont inactives (ou ouvertes) dans cette phase d'écriture.

Dans la phase de lecture, par exemple du point mémoire 114₁, la "ligne de bit conjuguée" 112₁ associée à ce point mémoire est ouverte, ainsi que toutes les autres lignes de bit conjuguée" 112₂, etc... de façon à empêcher tout courant d'y circuler. La ligne de polarisation 115 associée au point mémoire envisagé est portée à un potentiel permettant le passage du courant de lecture (faible) dans la jonction tunnel ou dans la vanne de spin, tandis que toutes les autres lignes de polarisation 115', etc... sont déconnectées. La «ligne de mot» 110 associée est portée au potentiel permettant la fermeture du transistor 113₁ et un courant peut donc passer à travers la jonction tunnel ou la vanne de spin entre les points C et A. Pour ne lire que cette jonction tunnel ou cette vanne de spin, les autres lignes de mot « word line » 110', etc... sont ouvertes. Dans le cas d'une jonction tunnel, la lecture peut alors se faire par exemple suivant l'état de l'art par comparaison au moyen d'un amplificateur du courant passant dans la jonction à un courant de référence. Ce courant de lecture de faible densité de courant, passant perpendiculairement aux plans de l'empilement ne permet pas d'écrire la jonction dans cette phase de lecture. La procédure est la même dans le cas d'une vanne de spin.

## Revendications

1. Système d'écriture d'un élément magnétique inscriptible comportant un empilement de couches présentant une couche magnétique d'écriture, dans lequel l'empilement comporte une couche centrale (13, 53, 90) en au moins un matériau magnétique présentant une direction d'aimantation perpendiculaire au plan de la couche centrale, celle-ci, qui constitue une dite couche magnétique d'écriture, étant prise en sandwich entre une première (12, 52, 91) et une deuxième (14, 54, 92) couches externes en matériaux non magnétiques, la première couche externe (12, 52, 91) comportant un premier matériau non magnétique et la deuxième couche externe (14, 54, 92) comportant un deuxième matériau non magnétique différent du premier matériau non magnétique, au moins le deuxième matériau non magnétique étant électriquement conducteur, le système comportant d'une part un dispositif pour faire passer un courant d'écriture seulement à travers la deuxième couche externe et la couche centrale, et éventuellement à travers la première couche externe seulement dans le cas où celle-ci est conductrice, ce courant d'écriture circulant dans une direction de courant parallèle au plan de la couche centrale, et d'autre part un dispositif pour appliquer en présence dudit courant d'écriture un champ magnétique d'écriture selon une direction de champ magnétique perpendiculaire au plan de la couche centrale (13, 53, 90) et des moyens d'inversion du sens du champ magnétique, ledit élément magnétique étant apte à être écrit dans un sens d'aimantation ou dans l'autre en agissant sur le sens du champ magnétique d'écriture qui est appliqué.

2. Système selon la revendication 1, **caractérisé en ce que** la couche centrale (13, 53, 90) a une épaisseur comprise entre 0,1 nm et 5 nm et de préférence inférieure ou égale à 2 nm.

3. Système selon une des revendications 1 ou 2, **caractérisé en ce que** la couche centrale (13, 53, 90) comporte un composé magnétique présentant une anisotropie magnétique perpendiculaire propre, à savoir, notamment un alliage FePt, FePd, CoPt, CoPd ou bien encore un alliage de terre rare / métal de transition, notamment GdCo, TbFeCo.

4. Système selon une des revendications 1 ou 2, **caractérisé en ce que** la couche centrale (13, 53, 90) comporte un métal ou un alliage présentant une anisotropie magnétique perpendiculaire induite par les interfaces, notamment Co, Fe, CoFe, Ni, CoNi.

5. Système selon une des revendications précédentes, **caractérisé en ce qu'**au moins une couche externe conductrice est en un métal non-magnétique, à savoir Pt, Pd, Cu, Au, Bi, Ir, Ru, W ou en un alliage de ces métaux.

6. Système selon une des revendications précédentes, **caractérisé en ce que** la première couche externe est en un oxyde diélectrique tel que SiOx, AlOx, MgOx, TiOx, TaOx, HfOx ou en un nitrure diélectrique tel que SiNx, BNx.

7. Système selon une des revendications 1 à 5, **caractérisé en ce que** les deux couches externes sont conductrices et sont en deux dits matériaux ou alliages non magnétiques différents.

8. Système selon une des revendications précédentes, **caractérisé en ce que** la première couche externe (52) est recouverte d'une couche de lecture (58) en matériau magnétique et d'une électrode de lecture (59).

9. Système selon la revendication 8, **caractérisé en ce que** la première couche externe (52) est en métal non-magnétique et **en ce qu'**elle forme avec la couche centrale (53), la couche de lecture (58) et l'électrode de lecture (59) une vanne de spin.

10. Système selon la revendication 8, **caractérisé en ce que** la première couche externe (52) est diélectrique et **en ce qu'**elle forme avec la couche centrale (53), la couche de lecture (58) et l'électrode de lecture (59) une jonction tunnel magnétique.

11. Système selon une des revendications 8 à 10, **caractérisé en ce que** l'épaisseur de la première couche externe (52) est inférieure à 5 nm et plus particulièrement inférieure à 3 nm.

12. Système selon une des revendications précédentes, **caractérisé en ce que** la première couche externe et la couche centrale forment un plot et **en ce que** la deuxième couche externe forme éventuellement une piste.

13. Système selon la revendication 12, **caractérisé en ce que** la deuxième couche externe comporte une région en surépaisseur qui fait partie du plot.

14. Dispositif magnétique inscriptible, **caractérisé en ce qu'**il comporte une pluralité de plots selon une des revendications 12 ou 13, dont la deuxième couche externe comporte une dite piste qui leur est commune.

15. Dispositif magnétique inscriptible, **caractérisé en ce que** la première couche externe, la couche centrale et la région en surépaisseur de la deuxième couche externe forment un plot selon la revendication 13, et **en ce qu'**il comporte une pluralité desdits plots, ainsi d'une piste électriquement conductrice bordant la deuxième couche externe desdits plots pour injecter ledit courant à travers la deuxième couche externe et la couche centrale de chacun desdits plots, la deuxième couche externe étant en un matériau électriquement conducteur différent de celui de la piste électriquement conductrice.

## Patentansprüche

1. System zum Beschreiben eines beschreibbaren magnetischen Elements, das eine Stapelung von Schichten umfasst, die eine magnetische Schreibschicht aufweisen, wobei die Stapelung eine mittlere Schicht (13, 53, 90) aus mindestens einem magnetischen Material umfasst, das eine Magnetisierungsrichtung aufweist, die senkrecht zur Ebene der mittleren Schicht ist, wobei diese, die eine so genannte magnetische Schreibschicht bildet, zwischen einer ersten (12, 52, 91) und einer zweiten (14, 54, 92) äußeren Schicht aus nichtmagnetischen Materialien angeordnet ist, wobei die erste äußere Schicht (12, 52, 91) ein erstes nichtmagnetisches Material umfasst und die zweite äußere Schicht (14, 54, 92) ein zweites nichtmagnetisches Material umfasst, das sich von dem ersten nichtmagnetischen Material unterscheidet, wobei zumindest das zweite nichtmagnetische Material elektrisch leitfähig ist, wobei das System einerseits eine Vorrichtung, um einen Schreibstrom einzig durch die zweite äußere Schicht und die mittlere Schicht und gegebenenfalls durch die erste äußere Schicht lediglich in dem Fall, in dem diese leitfähig ist, fließen zu lassen, wobei dieser Schreibstrom in eine Stromrichtung fließt, die parallel zur Ebene der mittleren Schicht ist, und andererseits eine Vorrichtung, um beim Vorhandensein des Schreibstroms ein Magnetfeld zum Schreiben entlang einer Magnetfeldrichtung anzulegen, die senkrecht zur Ebene der mittleren Schicht (13, 53, 90) ist, und Mittel zur Umkehrung der Richtung des Magnetfelds umfasst, wobei das magnetische Element geeignet ist, in einer Magnetisierungsrichtung oder in der anderen beschrieben zu werden, indem auf die Richtung des Magnetfelds zum Schreiben, das angelegt wird, eingewirkt wird.

2. System nach Anspruch 1, **dadurch gekennzeichnet, dass** die mittlere Schicht (13, 53, 90) eine Dicke aufweist, die zwischen 0,1 nm und 5 nm enthalten ist und vorzugsweise kleiner oder gleich 2 nm ist.

3. System nach einem der Ansprüche 1 oder 2, **dadurch gekennzeichnet, dass** die mittlere Schicht (13, 53, 90) eine magnetische Verbindung, die eine eigene senkrechte magnetische Anisotropie aufweist, nämlich insbesondere eine FePt-, FePd-, CoPt-, CoPd-Legierung oder auch eine Legierung aus seltenen Erden / Übergangsmetall, insbesondere GdCo, TbFeCo, umfasst.

4. System nach einem der Ansprüche 1 oder 2, **dadurch gekennzeichnet, dass** die mittlere Schicht (13, 53, 90) ein Metall oder eine Legierung umfasst, die eine senkrechte magnetische Anisotropie aufweist, die durch die Grenzflächen induziert wird, insbesondere Co, Fe, CoFe, Ni, CoNi.

5. System nach einem der vorhergehenden Ansprüche, **dadurch gekennzeichnet, dass** mindestens eine leitfähige äußere Schicht aus einem nichtmagnetischen Metall, nämlich Pt, Pd, Cu, Au, Bi, Ir, Ru, W oder aus einer Legierung dieser Metalle, hergestellt ist.

6. System nach einem der vorhergehenden Ansprüche, **dadurch gekennzeichnet, dass** die erste äußere Schicht aus einem dielektrischen Oxid, wie beispielsweise SiOx, AlOx, MgOx, TiOx, TaOx, HfOx, oder aus einem dielektrischen Nitrid, wie beispielsweise SiNx, BNx, hergestellt ist.

7. System nach einem der Ansprüche 1 bis 5, **dadurch gekennzeichnet, dass** die zwei äußeren Schichten leitfähig sind und aus zwei der unterschiedlichen nichtmagnetischen Materialien oder Legierungen hergestellt sind.

8. System nach einem der vorhergehenden Ansprüche, **dadurch gekennzeichnet, dass** die erste äußere Schicht (52) durch eine Leseschicht (58) aus magnetischem Material und eine Leseelektrode (59) bedeckt ist.

9. System nach Anspruch 8, **dadurch gekennzeichnet, dass** die erste äußere Schicht (52) aus nichtmagnetischem Metall hergestellt ist, und dadurch, dass sie mit der mittleren Schicht (53), der Leseschicht (58) und der Leseelektrode (59) ein Spinventil bildet.

10. System nach Anspruch 8, **dadurch gekennzeichnet, dass** die erste äußere Schicht (52) dielektrisch ist, und dadurch, dass sie mit der mittleren Schicht (53), der Leseschicht (58) und der Leseelektrode (59) einen magnetischen Tunnelübergang bildet.

11. System nach einem der Ansprüche 8 bis 10, **dadurch gekennzeichnet, dass** die Dicke der ersten äußeren Schicht (52) kleiner als 5 nm und insbesondere kleiner als 3 nm ist.

12. System nach einem der vorhergehenden Ansprüche, **dadurch gekennzeichnet, dass** die erste äußere Schicht und die mittlere Schicht einen Kontakt bilden, und dadurch, dass die zweite äußere Schicht gegebenenfalls eine Spur bildet.

13. System nach Anspruch 12, **dadurch gekennzeichnet, dass** die zweite äußere Schicht eine Region mit Überdicke umfasst, die Teil des Kontakts ist.

14. Beschreibbare magnetische Vorrichtung, **dadurch gekennzeichnet, dass** sie mehrere Kontakte nach einem der Ansprüche 12 oder 13 umfasst, deren zweite äußere Schicht eine Spur umfasst, die ihnen gemein ist.

15. Beschreibbare magnetische Vorrichtung, **dadurch gekennzeichnet, dass** die erste äußere Schicht, die mittlere Schicht und die Schicht mit Überdicke der zweiten äußeren Schicht einen Kontakt nach Anspruch 13 bilden, und dadurch, dass sie mehrere der Kontakte sowie eine elektrisch leitfähige Spur umfasst, die die zweite äußere Schicht der Kontakte einfasst, um den Strom durch die zweite äußere Schicht und die mittlere Schicht von jedem der Kontakte zu injizieren, wobei die zweite äußere Schicht aus einem elektrisch leitfähigen Material hergestellt ist, das sich von demjenigen der elektrisch leitfähigen Spur unterscheidet.

## Claims

1. A writable magnetic element writing system comprising a stack of layers presenting a write magnetic layer, wherein the stack has a central layer (13, 53, 90) of at least one magnetic material presenting a direction of magnetization that is perpendicular to the plane of the central layer, said central layer, which constitutes a said write magnetic layer, being sandwiched between first (12, 52, 91) and second (14, 54, 92)outer layers of non-magnetic materials, the first outer layer (12, 52, 91) comprising a first non-magnetic material and the second outer layer (14, 54, 92) comprising a second non-magnetic material that is different from the first non-magnetic material,
at least the second non-magnetic material being electrically conductive, the system comprising on the one hand a device for causing a write current to flow only through the second outer layer and the centreal layer, and possibly through the first outer layer only if the latter is conductive, in a current flow direction parallel to the plane of the central layer, and on the other hand a device for applying, in the presence of said write current, a write magnetic field along a magnetic field direction that is perpendicular to the plane of the central layer (13, 53, 90), the memory being written in a direction or the other one by acting on the direction of the applied write magnetic field.

2. A system according to claim 1, **characterized in that** the central layer (13, 53, 90) has a thickness lying in the range 0.1 nm to 5 nm, and preferably less than or equal to 2 nm.

3. A system according to claim 1 or claim 2, **characterized in that** the central layer (13, 53, 90) comprises a magnetic compound presenting its own perpendicular magnetic anisotropy, i.e., in particular an alloy of FePt, FePd, CoPt, CoPd, or indeed an alloy of a rare earth and a transition metal, in particular GdCo, TdFeCo.

4. A system according to claim 1 or claim 2, **characterized in that** the central layer (13, 53, 90) comprises a metal or a metal alloy presenting perpendicular magnetic anisotropy induced by the interfaces, in particular Co, Fe, CoFe, Ni, CoNi.

5. A system according to any preceding claim, **characterized in that** at least one outer conductive layer is made of a non-magnetic metal, i.e. Pt, Pd, Cu, Au, Bi, Ir, Ru, W or out of an alloy of these metals.

6. A system according to any preceding claim, **characterized in that** the first outer layer is made of a dielectric oxide such as SiOₓ, AlOₓ, MgOₓ, TiOₓ, TaOₓ, HfOₓ, or out of a dielectric nitride such as SiNₓ, BNₓ.

7. A system according to any one of claims 1 to 5, **characterized in that** the two outer layers are conductive and are both made of different ones of said non-magnetic materials or alloys.

8. A system according to any preceding claim, **characterized in that** the first outer layer (52) is covered in a read layer (58) of magnetic material and by a read electrode (59) .

9. A system according to claim 12, **characterized in that** the first outer layer (52) is made of non-magnetic metal and **in that** it co-operates with the central layer (53), the read layer (58), and the read electrode (59) to form a spin valve.

10. A system according to claim 8, **characterized in that** the first outer layer (52) is dielectric and **in that** it co-operates with the central layer (53), the read layer (58) and the read electrode (59) to form a magnetic tunnel junction.

11. A system according to any one of claims 8 to 10, **characterized in that** the thickness of the first outer layer (52) is less than 5 nm, and more particularly less than 3 nm.

12. A system according to any preceding claim, **characterized in that** the first outer layer and the central layer form a stud and **in that** the second outer layer forms possibly a track.

13. A system according to claim 12, **characterized in that** the second outer layer includes a region of extra thickness that forms part of the stud.

14. A writable magnetic device, **characterized in that** it includes a plurality of studs according to claim 12 or claim 13, with the second outer layer thereof including a said track that is common to the studs.

15. A writable magnetic device, **characterized in that** the first outer layer, the central layer, and the region of extra thickness of the second outer layer form a stud according to claim 13, and **in that** the device includes a plurality of said studs, together with an electrically conductive track beside the second outer layer of said stud to inject said current through the second outer layer and the central layer of each of said studs, the second outer layer being made of an electrically conductive material different from the material of the electrically conductive track.
